# EUROPÄISCHE PATENTANMELDUNG

(11) **EP 4 112 226 A1**
(43) Veröffentlichungstag der Anmeldung: **04.01.2023**
(21) Anmeldenummer: 21183197.9
(22) Anmeldetag: 01.07.2021
(51) Int. Cl.: B23Q 17/22, B23B 5/02, B23B 29/24, G01B 7/00, H03K 17/97

(54) **ZERSPANUNGSWERKZEUG**

(71) Anmelder: KOMET Deutschland GmbH, 74354 Besigheim (DE)
(72) Erfinder: Gärtner, Urban, 74354 Besigheim (DE); Pörschke, Jörg, 74354 Besigheim (DE); Schweiker, Albrecht, 74354 Besigheim (DE); Mack, Markus, 74354 Besigheim (DE); Gellert, Kai, 74354 Besigheim (DE)
(74) Vertreter: Ciesla, Dirk

(57) **Zusammenfassung**

Es wird ein Zerspanungswerkzeug (1) bereitgestellt, wobei das Zerspanungswerkzeug (1) einen Werkzeugschlitten (2), eine Schlittenführung (13), ein Schneidelement (3) und ein weiteres Schneidelement (4) hat, wobei der Werkzeugschlitten (2) das Schneidelement (3) trägt, wobei die Schlittenführung (13) den Werkzeugschlitten (2) führt, wobei der Werkzeugschlitten (2) von der Schlittenführung (13) geführt von einer Referenzposition in eine Arbeitsposition verstellbar ist, wobei das Schneidelement (3) und das weitere Schneidelement (4) einen verstellbaren Zerspanungsspalt (5) bilden, wobei das Zerspanungswerkzeug (1) einen Positionsschalter (13a) und einen Positionssender (13e) hat, wobei der Positionsschalter (13a) und der Werkzeugschlitten (2) derart gekoppelt sind, dass, wenn sich der Werkzeugschlitten (2) in der Referenzposition befindet, der Positionsschalter (13b) eingeschaltet ist, und, wenn sich der Werkzeugschlitten (2) außerhalb von der Referenzposition befindet, der Positionsschalter (13b) ausgeschaltet ist.

## Beschreibung

Die vorliegende Erfindung betrifft ein Zerspanungswerkzeug, wobei das Zerspanungswerkzeug einen Werkzeugschlitten, eine Schlittenführung, ein Schneidelement und ein weiteres Schneidelement hat, wobei der Werkzeugschlitten das Schneidelement trägt, wobei die Schlittenführung den Werkzeugschlitten führt, wobei der Werkzeugschlitten von der Schlittenführung geführt von einer Referenzposition in eine Arbeitsposition verstellbar ist, wobei das Schneidelement und das weitere Schneidelement einen verstellbaren Zerspanungsspalt bilden.

Die DE 35 28 437 A1 zeigt eine Vorrichtung für eine Drehmaschine zum beidseitigen und gleichzeitigen Drehen scheibenförmiger, umlaufender Werkstücke mittels einander gegenüberliegender Werkzeuge.

Bei der aus der DE 35 28 437 A1 bekannten Vorrichtung ist das Referenzieren der Werkzeuge aufwendig.

Die technische Aufgabe der vorliegenden Erfindung besteht darin, ein Zerspanungswerkzeug bereitzustellen, bei dem die Referenzposition von dem Werkzeugschlitten einfach und zugleich präzise erfasst wird.

Die technische Aufgabe der vorliegenden Erfindung wird gelöst durch den Gegenstand von Anspruch 1. Vorteilhafte Weiterbildungen der Erfindung sind den abhängigen Ansprüchen, die untereinander frei kombinierbar sind, und den beigefügten Figuren zu entnehmen.

Das Zerspanungswerkzeug hat einen Werkzeugschlitten, eine Schlittenführung, ein Schneidelement und ein weiteres Schneidelement, wobei der Werkzeugschlitten das Schneidelement trägt, wobei die Schlittenführung den Werkzeugschlitten führt, wobei der Werkzeugschlitten von der Schlittenführung geführt von einer Referenzposition in eine Arbeitsposition verstellbar ist, wobei das Schneidelement und das weitere Schneidelement einen verstellbaren Zerspanungsspalt bilden, wobei das Zerspanungswerkzeug einen Positionsschalter und einen Positionssender hat, wobei der Positionsschalter und der Werkzeugschlitten derart gekoppelt sind, dass, wenn sich der Werkzeugschlitten in der Referenzposition befindet, der Positionsschalter eingeschaltet ist, und, wenn sich der Werkzeugschlitten außerhalb von der Referenzposition befindet, der Positionsschalter ausgeschaltet ist, wobei der Positionssender mit dem Positionsschalter derart verbunden ist, dass, wenn der Positionsschalter eingeschaltet ist, der Positionssender ein Referenzpositionssignal sendet, und, wenn der Positionsschalter ausgeschaltet ist, der Positionssender das Referenzpositionssignal nicht sendet.

Das Zerspanungswerkzeug hat den Vorteil, dass die Referenzposition von dem Werkzeugschlitten ohne aufwendige Wegmessung einfach und zugleich präzise erfasst wird. So reicht es aus, den Werkzeugschlitten von der Schlittenführung geführt ausgehend von einer beliebigen Position so lange zu verstellen, bis der Positionsschalter eingeschaltet wird, was heißt, dass die Referenzposition erreicht wurde und das Referenzpositionssignal von dem Positionssender gesendet wird.

Wird der Werkzeugschlitten von der Schlittenführung geführt von der Referenzposition weg bewegt, wird der Positionsschalter ausgeschaltet, was heißt, dass die Verstellung von dem Werkzeugschlitten anhand einer inkrementellen Größe relativ zu der Referenzposition bestimmt werden kann. Die inkrementelle Größe kann zum Beispiel eine Spindeldrehzahl sein, wenn das Zerspanungswerkzeug bezüglich des Werkzeugschlittens einen Spindelantrieb mit einer Spindel hat, wobei die Spindeldrehzahl bezüglich einer Spindelachse von der Spindel bemessen ist.

Geht die Werkzeugschlittenposition in Form von in einem elektronischen Speicher abgespeicherter Daten verloren oder wird die Werkzeugschlittenposition erst gar nicht abgespeichert, kommt der Vorteil des Zerspanungswerkzeugs erst recht zum Tragen, weil ohne Wegmessung erfasst wird, wann sich der Werkzeugschlitten in der Referenzposition befindet, und zwar, wenn der Positionsschalter eingeschaltet ist.

Das Schneidelement ist vorzugsweise reversibel lösbar mit einem Schneidelementhalter verbunden, wobei der Schneidelementhalter mit dem Werkzeugschlitten reversibel lösbar verbunden ist.

Das Zerspanungswerkzeug hat vorzugsweise einen gegenüberliegend von dem Schneidelement angeordneten sowie ausgebildeten Halterungsarm, wobei der Halterungsarm das weitere Schneidelement trägt. Der Halterungsarm kann einteilig oder mehrteilig ausgebildet sein. Vorzugsweise ist das weitere Schneidelement reversibel lösbar mit einem weiteren Schlitten verbunden, der unter einer Verstellung von dem Werkzeugschlitten in einer stationären Position verbleibt und eine Feinverstellung in eine Richtung senkrecht zu einer Erstreckung von dem Zerspanungsspalt hat. Der weitere Schlitten ist vorzugweise reversibel lösbar mit dem Halterungsarm verbunden.

Der Zerspanungsspalt erstreckt sich vorzugsweise zwischen zwei einander gegenüberliegenden Schneidecken von dem Schneidelement und dem weiteren Schneidelement.

Der Werkzeugschlitten ist von der Schlittenführung geführt zumindest in eine beliebige Zwischenposition verstellbar, wobei die Zwischenposition zwischen der Referenzposition und der Arbeitsposition liegt.

Die Schlittenführung hat vorzugsweise eine gerade virtuellen Verstellachse, so dass der Werkzeugschlitten von der Schlittenführung linear entlang der virtuellen Verstellachse geführt wird, wobei eine Zerspanungsspaltweite von dem Zerspanungsspalt vorzugsweise parallel zu der virtuellen Verstellachse bemessen ist.

Die Schlittenführung kann einteilig oder mehrteilig ausgebildet sein.

Gemäß einer Weiterbildung trägt die Schlittenführung den Positionsschalter, wobei der Werkzeugschlitten einen Schalterbetätigungsbereich hat, wobei der Schalterbetätigungsbereich den Positionsschalter in der Referenzposition kontaktlos einschaltet. Diese Weiterbildung hat den Vorteil, dass der Positionsschalter ohne Kontakt mit dem Schalterbetätigungsbereich von dem Schalterbetätigungsbereich eingeschaltet wird, was den Verschleiß jeweils aufseiten des Schalterbetätigungsbereichs und aufseiten des Positionsschalters reduziert.

Der Schalterbetätigungsbereich kann zum Beispiel ein magnetisches Feld haben, welches mit dem Schalterbetätigungsbereich und damit mit dem Werkzeugschlitten verstellt wird und in der Referenzposition den Positionsschalter einschaltet, wobei der Positionsschalter zum Beispiel als Sensor ausgebildet sein kann, welcher das magnetisches Feld detektiert und bei Erreichen einer vorgegebenen Magnetfeldstärke ein Einschaltkriterium erfüllt und damit eingeschaltet ist, oder wobei der Positionsschalter mindestens eine Schaltwippe hat, wobei die Schaltwippe bei Erreichen einer vorgegebenen Magnetfeldstärke bewegt wird und einen mechanischen Schaltkontakt in dem Positionsschalter schließt. Der Betätigungsbereich kann aber auch eine Kante von dem Werkzeugschlitten sein, wobei die Kante einen Wirbelstrom in den Positionsschalter induziert, wobei der Positionsschalter ein induktiver Sensor ist.

Gemäß einer Weiterbildung hat der Schalterbetätigungsbereich einen Magneten und ist der Positionsschalter auf Basis eines von dem Magneten erzeugten Magnetfelds einschaltbar ausgebildet und angeordnet. Diese Weiterbildung ist vorteilhaft, weil der Magnet ein zeitlich stabiles Magnetfeld bereitstellt und zugleich kostengünstig herstellbar ist. Der Positionsschalter ist nach dieser Weiterbildung zum Beispiel als Sensor ausgebildet, welcher das magnetische Feld detektiert und bei Erreichen einer vorgegebenen Magnetfeldstärke ein Einschaltkriterium erfüllt und damit eingeschaltet ist. Das Einschaltkriterium kann zum Beispiel lauten, dass 50 % oder mehr, vorzugsweise mehr als 80 %, von einer durch den Magneten erzeugten Maximalfeldstärke detektiert werden. Ein solches Einschaltkriterium kann zum Beispiel in einem Mikroprozessor hinterlegt sein, wobei der Mikroprozessor ein Bestandteil von dem Positionsschalter ist. Der Positionsschalter kann nach dieser Weiterbildung aber auch mindestens eine Schaltwippe haben, wobei die Schaltwippe bei Erreichen einer vorgegebenen Magnetfeldstärke bewegt wird und so einen mechanischen Schaltkontakt in dem Positionsschalter schließt. Ist der Schaltkontakt geschlossen, sendet der Positionssender das Referenzpositionssignal, ist der Schaltkreis offen, sendet der Positionssender das Referenzpositionssignal nicht. Denkbar und auch möglich ist es aber auch, dass der Positionsschalter ohne mechanischen Schaltkontakt ausgebildet ist, sondern einen oder mehrere Transistoren und/oder eine oder mehrere Dioden jeweils zum Schalten hat.

Der Magnet kann als zylindrischer Körper ausgebildet sein, wobei eine Bodenfläche von diesem Körper dem Positionsschalter in der Referenzposition von dem Werkzeugschlitten zugewandt angeordnet ist.

Gemäß einer Weiterbildung erstreckt sich der Positionsschalter im Wesentlichen senkrecht zu einer virtuellen Verstellachse von dem Werkzeugschlitten. Diese Weiterbildung ist vorteilhaft, weil die Detektionsfläche aufseiten des Positionsschalters bezüglich des Betätigungsbereichs erhöht wird. Mit "im Wesentlichen senkrecht" ist gemeint, dass der Positionsschalter eine Schalterlängsachse hat, wobei die Schalterlängsachse mit der virtuellen Verstellachse einen Winkel im Bereich von 75° bis 105° bildet, einschließlich 90°, wobei der Winkel aufseiten des Positionsschalter bemessen ist.

Gemäß einer Weiterbildung ist der Positionssender zum kabellosen Senden des Referenzpositionssignals ausgebildet und angeordnet. Diese Weiterbildung ist vorteilhaft, weil das Referenzpositionssignal räumlich besonders flexibel gesendet wird. Mit kabellos ist zum Beispiel gemeint, dass das Referenzpositionssignal funkgebunden, zum Beispiel nach einem Industriestandard codiert wie zum Beispiel Bluetooth, oder optisch, zum Beispiel durch optische Signale im Infrarotlichtbereich, gesendet wird.

Gemäß einer Weiterbildung ist der Positionssender zum funkgebundenen Senden des Referenzpositionssignals ausgebildet und angeordnet. Diese Weiterbildung ist vorteilhaft, weil das Referenzpositionssignal räumlich besonders flexibel gesendet wird. Der Positionssender hat für das funkgebundene Senden eine Antenne. Die Antenne ist vorzugsweise in einen Schaltkreis integriert, wobei der Schaltkreis ein Bestandteil von dem Positionssender ist.

Gemäß einer Weiterbildung hat das Zerspanungswerkzeug einen reversibel lösbaren Energiespeicher, wobei der Energiespeicher zur Energieversorgung von dem Positionssender und/oder von dem Positionsschalter ausgebildet und angeordnet ist, wobei der Energiespeicher in die Schlittenführung eingelassen angeordnet ist. Diese Weiterbildung ist vorteilhaft, weil sie das Zerspanungswerkzeug bezüglich der Energieversorgung von dem Positionssender beziehungsweise dem Positionsschalter autark macht. Der Energiespeicher kann zum Beispiel eine oder mehrere elektrochemische Zellen haben.

Gemäß einer Weiterbildung hat das Zerspanungswerkzeug eine Anzeige, wobei die Anzeige derart ausgebildet und angeordnet ist, dass, wenn sich der Werkzeugschlitten in der Referenzposition befindet, die Anzeige auf Basis des Referenzpositionssignals ein bezüglich des Referenzpositionssignals weiteres Referenzpositionssignal optisch anzeigt, und, wenn sich der Werkzeugschlitten außerhalb der Referenzposition befindet, die Anzeige das weitere Referenzpositionssignal nicht anzeigt. Diese Weiterbildung macht die Bedienung von dem Zerspanungswerkzeug besonders einfach, weil ein Bediener von der Anzeige ablesen kann, ob die Referenzposition erreicht ist oder nicht. Die Anzeige kann eine Leuchtdiode haben, wobei das weitere Referenzpositionssignal das Leuchten von der Leuchtdiode ist.

Gemäß einer Weiterbildung hat das Zerspanungswerkzeug eine Spannpratze, wobei die Spannpratze das Schneidelement reversibel lösbar fixiert. Die Spannpratze fixiert das Schneidelement, ohne dass dafür eine Durchgangsbohrung zur Aufnahme eine Spannschraube aufseiten des Schneidelements nötig ist, eine strukturelle Schwächung von dem Schneidelement also vermieden wird.

Gemäß einer Weiterbildung hat das Zerspanungswerkzeug eine Spindel, wobei die Spindel mit dem Werkzeugschlitten derart im Eingriff steht, so dass der Werkzeugschlitten unter einer Spindeldrehung von der Spindel bezüglich einer Spindeldrehachse von der Spindel parallel zur Spindeldrehachse sowie relativ zur Spindel verstellt wird. Die Spindel macht die Verstellung von dem Werkzeugschlitten besonders präzise und erlaubt zugleich eine Verstellung von dem Werkzeugschlitten zwischen verschiedenen Schlittenpositionen auf Basis eines einfachen Steuerbefehls, wobei der Steuerbefehl auf einer inkrementellen Spindeldrehzahl basiert. Die inkrementelle Spindeldrehzahl kann zum Beispiel bezüglich der Referenzposition bemessen sein.

Gemäß einer Weiterbildung hat das Zerspanungswerkzeug eine Antriebseinheit und eine Steuereinheit, wobei die Antriebseinheit derart ausgebildet und angeordnet ist, dass die Antriebseinheit in einem aktivierten Zustand die Spindel bezüglich der Spindeldrehachse drehantreibt, wobei die Steuereinheit derart ausgebildet und angeordnet ist, dass die Steuereinheit die Antriebseinheit auf Basis von einem Steuerbefehl aktiviert, wobei der Steuerbefehl ein codierter Betrag von einer Drehzahl von der Spindel bezüglich der Spindeldrehachse ist. Die Antriebseinheit und die Steuereinheit sorgen dafür, dass der Werkzeugschlitten auf Basis des Referenzpositionssignals verstellt wird.

Gemäß einer Weiterbildung ist die Steuereinheit derart ausgebildet und angeordnet, dass die Steuereinheit in einem Referenzierzustand die Antriebseinheit auf Basis von einem Referenzierbefehl aktiviert, so dass der Werkzeugschlitten in dem Referenzierzustand von der Steuereinheit verstellt wird, bis der Positionsschalter eingeschaltet ist. Bei dieser Weiterbildung lässt sich der Werkzeugschlitten besonders einfach automatisch referenzieren, indem der Werkzeugschlitten so lange verstellt wird, bis der Positionsschalter eingeschaltet ist, weil dann die Referenzposition erreicht ist. Ein optische Inspektion oder Wegmessung entfällt jeweils bezüglich der Frage, ob die Referenzposition erreicht wurde.

Gemäß einer Weiterbildung hat das Zerspanungswerkzeug einen Schneidelementhalter, wobei das Schneidelement reversibel lösbar mit dem Schneidelementhalter verbunden ist, wobei der Schneidelementhalter reversibel lösbar mit dem Werkzeugschlitten verbunden ist und gegen einen verstellbaren Anschlag anschlägt, wobei der Schneidelementhalter in einem bezüglich des Werkzeugschlittens reversibel gelösten Zustand sowie bezüglich eines gegenüber einer Ausgangsstellung verstellten Zustands des Anschlags relativ zu dem Werkzeugschlitten verstellbar ist, so dass der Zerspanungsspalt unter einer Verstellung von dem Schneidelementhalter relativ zum Werkzeugschlitten verstellt wird und der Werkzeugschlitten nach der Verstellung gegen den Anschlag anschlägt. Diese Weiterbildung ist vorteilhaft, weil sie das Schneidelement feinverstellbar macht. Der Anschlag kann ein Wellelement haben, das in den Werkzeugschlitten quer zu einer virtuellen Verstellachse von dem Werkzeugschlitten eingelassen ist, und ein weiteres Wellenelement, das in den Schneidelementhalter quer zur virtuellen Verstellachse von dem Werkzeugschlitten eingelassen ist, wobei das Wellenelement und das weitere Wellenelement miteinander verbunden sind, wobei das Wellenelement und das weitere Wellenelement jeweils eine Längsachse haben, entlang welcher sie sich jeweils erstrecken, wobei die Längsachsen parallel zueinander verlaufen, aber nicht fluchten. Das weitere Wellenelement ist also exzentrisch zu der Längsachse von dem Wellenelement angeordnet, so dass die Längsachse von dem weiteren Wellenelement die Längsachse von dem Wellenelement unter einer Drehung von dem Wellenelement umkreist und eine Bewegungskomponente parallel zur virtuellen Verstellachse und eine weitere Bewegungskomponente senkrecht zu einer Ebene hat, wobei die Ebene die Längsachse von dem Wellenelement unter einer beliebigen Drehung enthält. Der Schneidelementhalter schlägt nach abgeschlossener Drehung, die auch als Verstellung von dem Anschlag bezeichnet werden kann, gegen das weitere Wellenelement an. Die Bewegungskomponente parallel zur virtuellen Verstellachse legt fest, wie weit der Schneidelementhalter und damit das Schneidelement relativ zum Werkzeugschlitten verstellt werden kann.

Gemäß einer Weiterbildung hat das Zerspanungswerkzeug ein Dämpfungselement, wobei das Dämpfungselement einen Scheibenkontaktkörper und ein Federelement hat, wobei das Federelement den Scheibenkontaktkörper bezüglich einer Ausgangsposition von dem Scheibenkontaktkörper reversibel rückstellbar lagert, wobei der Werkzeugschlitten das Dämpfungselement trägt, wobei das Dämpfungselement aufseiten des Zerspanungsspalts angeordnet ist. Das Dämpfungselement dämpft insbesondere Schwingungen, die beim Zerspanen von einer in den Zerspanungsspalt eingeführten Bremsscheibe auftreten können. Das Federelement kann eine Tellerfeder sein und der Scheibenkontaktkörper kann ein von dem Federelement gelagerter Kontaktstift sein. Der Kontaktstift besteht in vorteilhafterweise aus einem Hartmetall (cemented carbide), wobei das Hartmetall eine Skelettstruktur mit Zwischenräumen hat, wobei die Skelettstruktur aus einander gesinterten Wolframkarbidpartikeln besteht und die Zwischenräume mit einer Kobaltbasislegierung, einer Nickelbasislegierung oder einer Eisenbasislegierung gefüllt sind, wobei die Wolframkarbidpartikel jeweils mindestens 70 Gewichtsprozent von dem Hartmetall ausmachen, vorzugsweise mindestens 80 Gewichtsprozent, und die Kobaltbasislegierung mindestens 50 Gewichtsprozent Kobalt hat, die Nickelbasislegierung mindestens 50 Gewichtsprozent Nickel hat und die Eisenbasislegierung mindestens 50 Gewichtsprozent Eisen hat.

Gemäß einer Weiterbildung hat der Zerspanungspalt eine Referenzspaltweite in der Referenzposition, wobei der Zerspanungspalt eine Arbeitsspaltweite in der Arbeitsposition von dem Werkzeugschlitten hat, wobei das Schneidelement und das weitere Schneidelement derart gegenüberliegend zueinander angeordnet und ausgebildet sind, dass eine Bremsscheibe in den Zerspanungsspalt einführbar ist und unter einer relativen Drehung zu dem Schneidelement und dem weiteren Schneidelement auf eine der Arbeitsspaltweite folgende Scheibendicke reduzierbar ist. Das Zerspanungswerkzeug ist nach dieser Weiterbildung also zum Plandrehen der Bremsscheibe ausgebildet und angeordnet.

Gemäß einer Weiterbildung ist der Positionsschalter in die Schlittenführung eingelassen angeordnet. Diese Weiterbildung ist vorteilhaft, weil Bauraum aufseiten des Zerspanungswerkzeugs dadurch gespart wird, dass die Schlittenführung zur Halterung von dem Positionsschalter verwendet wird. Vorteilhafterweise ist der Positionsschalter vollständig in die Schlittenführung eingelassen angeordnet, weil dies ein Kollisionsrisiko von dem Positionsschalter mit dem Werkzeugschlitten beseitigt.

Weitere Vorteile und Zweckmäßigkeiten der Erfindung ergeben sich anhand der nachfolgenden Beschreibung von einem Ausführungsbeispiel unter Bezugnahme auf die beigefügten Figuren.

Von den Figuren zeigen
- Fig. 1:: eine schematische Darstellung von einem Zerspanungswerkzeug in einer Aufsicht;
- Fig. 2:: eine schematische Darstellung von dem Zerspanungswerkzeug von Fig. 1 in Blickrichtung von dem Pfeil II in Fig. 1;
- Fig. 3:: eine schematische Schnittdarstellung von dem Zerspanungswerkzeug von Fig. 1 gemäß den Schnittlinien A-A in Fig. 2;
- Fig. 4:: eine schematische Darstellung von dem Zerspanungswerkzeug von Fig. 1 in Blickrichtung von dem Pfeil IV in Fig. 1;
- Fig. 5a:: eine schematische Schnittdarstellung von dem Zerspanungswerkzeug von Fig. 1 gemäß den Schnittlinien R-R in Fig. 4;
- Fig. 5b:: eine schematische Schnittdarstellung von dem Zerspanungswerkzeug von Fig. 1 gemäß den Schnittlinien R-R in Fig. 4, wobei das Zerspanungswerkzeug gegenüber der Darstellung in Fig. 5a verstellt wurde;
- Fig. 6:: eine schematische Darstellung von dem Zerspanungswerkzeug von Fig. 1 in Blickrichtung von dem Pfeil VI in Fig. 2;
- Fig. 7:: eine schematische Schnittdarstellung von dem Zerspanungswerkzeug von Fig. 1 gemäß den Schnittlinien F-F in Fig. 6;
- Fig. 8a:: eine schematische Darstellung von einem Abschnitt von dem Zerspanungswerkzeug von Fig. 1;
- Fig. 8b:: einen vergrößerten Bereich von Fig. 8a;
- Fig. 9:: eine schematische Schnittdarstellung von dem Zerspanungswerkzeug im Bereich eines Dämpfungselements.

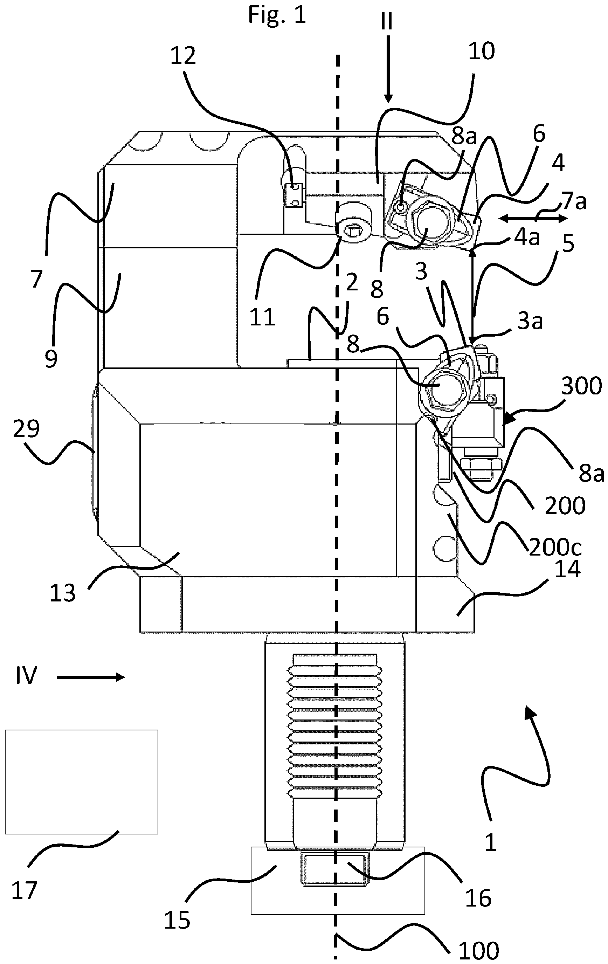

Fig. 1 zeigt ein Zerspanungswerkzeug 1 in einer Aufsicht. Das Zerspanungswerkzeug 1 hat einen Werkzeugschlitten 2, ein Schneidelement 3 und ein weiteres Schneidelement 4. Der Werkzeugschlitten 2 ist verstellbar und trägt das Schneidelement 3, so dass das Schneidelement 3 und der Werkzeugschlitten 2 gemeinsam parallel zu einer virtuellen Verstellachse 100 verstellt werden können.

Das Schneidelement 3 und das weitere Schneidelement 4 bilden einen Zerspanungsspalt 5, der unter einer Verstellung von dem Werkzeugschlitten 2 der Verstellung von dem Werkzeugschlitten 2 folgend verstellbar ist und damit eine parallel zur Verstellachse 100 bemessene Spaltweite hat.

Der Zerspanungsspalt 5 erstreckt sich zwischen zwei einander zugewandten Schneidecken 3a und 4a, so dass der Zerspanungsspalt 5 auch als virtuelle Verbindungsgerade betrachtet werden kann, welche die Schneidecken 3a und 4a miteinander verbindet und parallel zur Verstellachse 100 orientiert ist; die Schneidecke 3a ist eine Schneidecke von dem Schneidelement 3, die Schneidecke 4a von dem Schneidelement 4.

Das Schneidelement 3 ist reversibel lösbar mit einem Schneidelementhalter 200 verbunden, wobei der Schneidelementhalter 200 reversibel lösbar mit dem Werkzeugschlitten 2 verbunden ist, so dass unter einer Verstellung von dem Werkzeugschlitten 2 der Schneidelementhalter 200 und damit das Schneidelement 3 mit dem Werkzeugschlitten 2 mitverstellt werden.

Das Schneidelement 3 ist reversibel lösbar mit dem Schneidelementhalter 200 verbunden, indem eine Spannpratze 6 das Schneidelement 3 von oben gegen den Schneidelementhalter 200 drückt. Die Spannpratze 6 ist durch eine Pratzenschraube 8 reversibel lösbar mit dem Schneidelementhalter 200 verbunden, weil die Pratzenschraube 8 in den Schneidelementhalter 200 eingeschraubt ist und die Spannpratze 6 kontaktiert. Die Spannpratze 6 wird durch einen Sicherungsstift 8a gegen eine Verdrehung gesichert, indem der Sicherungsstift 8a jeweils in die Spannpratze 6 und den Schneidelementhalter 200 klemmend eingesteckt ist.

Das weitere Schneidelement 4 wird von einem Halterungsarm 7 getragen, wobei der Halterungsarm 7 mit einem Brückenabschnitt 9 reversibel lösbar verbunden ist, wobei der Brückenabschnitt 9 den Zerspanungsspalt 5 überspannt.

Das weitere Schneidelement 4 ist mit einem weiteren Schlitten 10 reversibel lösbar verbunden, wobei der weitere Schlitten 10 in einer stationären Position unter einer Verstellung von dem Werkzeugschlitten 2 verbleibt und den Halterungsarm 7 kontaktiert. Der weitere Schlitten 10 hat eine Feinverstellung, indem eine Befestigungsschraube 11, welche in ein nicht dargestelltes Langloch aufseiten des weiteren Schlittens 10 eingesteckt ist und mit dem Halterungsarm 7 verschraubt ist, gelöst wird und eine Verstellschraube 12 unter einem Kontakt mit dem Halterungsarm 7 gedreht wird, so dass eine solche Drehung in eine Verstellung, je nach Drehrichtung, in eine der beiden Richtungen von dem Doppelpfeil 7a aufseiten des weiteren Schlittens 10 umgewandelt wird. Mittels einer solchen Verstellung lässt sich das weitere Schneidelement 4 bei vorgegebener Position von dem Schneidelement 3 so verstellen, dass sich der Zerspanungsspalt 5 parallel zur Verstellachse 100 erstreckt.

Das weitere Schneidelement 4 ist dem Schneidelement 3 analog durch eine Spannpratze 6 mit dem weiteren Schlitten 10 reversibel lösbar verbunden, wobei die Spannpratze 6 der Spannpratze 6 aufseiten des Schneidelements 3 analog durch einen Sicherungsstift 8a gegen eine Verdrehung gesichert ist und durch eine Pratzenschraube 8 mit dem weiteren Schlitten 10 reversibel lösbar verbunden ist.

Der Werkzeugschlitten 2 wird von einer Schlittenführung 13 parallel entlang von der Verstellachse 100 geführt.

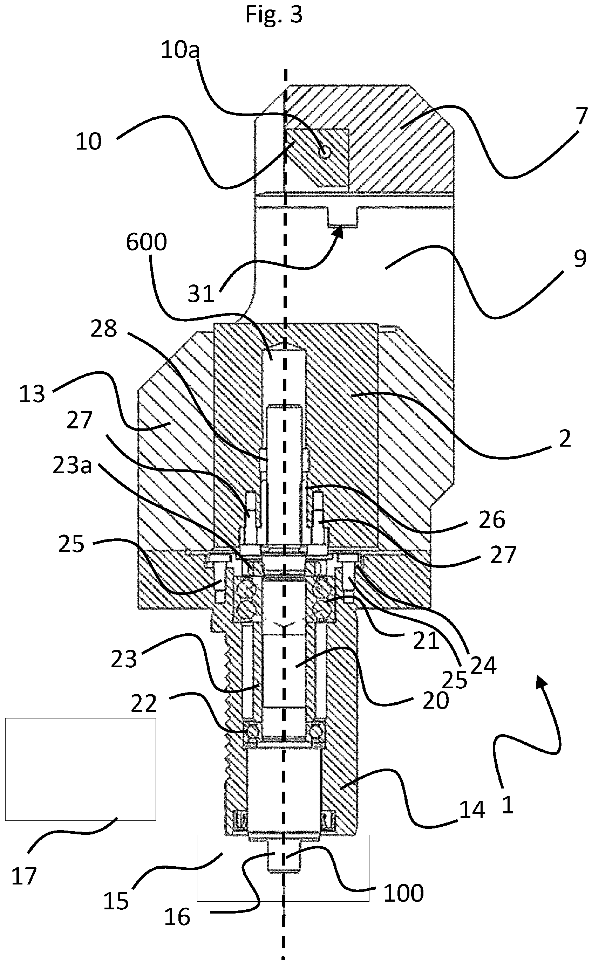

Das Zerspanungswerkzeug 1 hat ferner ein Flanschteil 14, welches aufseiten des Werkzeugschlittens 2 an die Schlittenführung 13 angeflanscht ist. Auf das Flanschteil 14 wird Bezug nehmend auf Fig. 3 näher eingegangen.

Das Zerspanungswerkzeug 1 hat ferner eine Antriebseinheit 15, welche mit einem Zweiflachelement 16 drehantreibbar verbunden ist (das Zweiflachelement 16 ist mit einer Spindel gekoppelt, welche den Werkzeugschlitten 2 unter einem Eingriff in ein Gewinde aufseiten des Werkzeugschlittens 2 verstellt). Die Antriebseinheit 15 ist mit einer Steuereinheit 17 datenempfangend verbunden, zum Beispiel durch ein Kabel oder kabellos, zum Beispiel funkgebunden oder optisch. Die Steuereinheit 17 sendet Steuerbefehle an die Antriebseinheit 15, welche auf Basis der Steuerbefehle das Zweiflachelement 16 und damit die Spindel beziehungsweise den Werkzeugschlitten 2 antreibt.

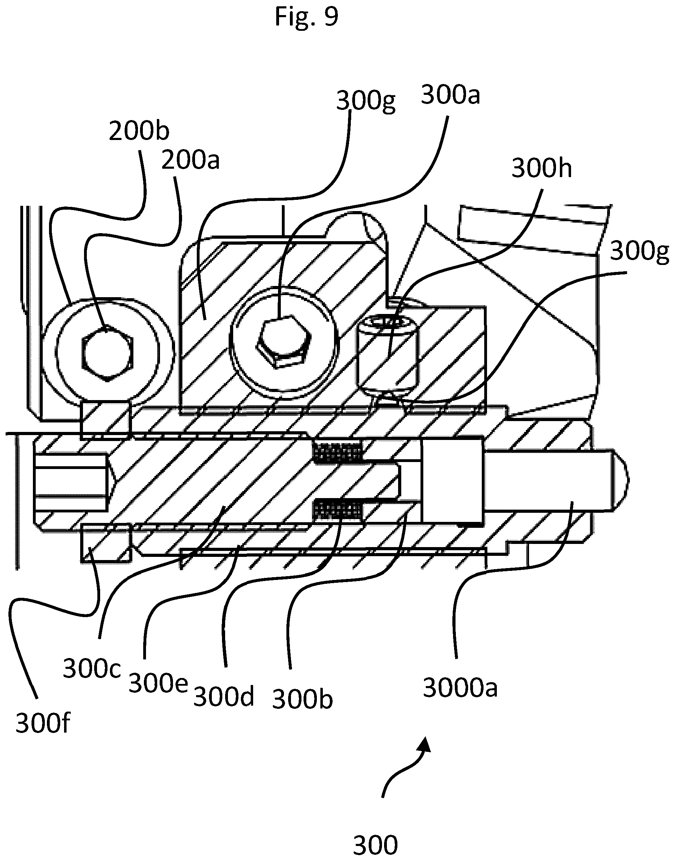

Das Zerspanungswerkzeug 1 hat ferner ein Dämpfungselement 300, auf welches Bezug nehmend auf Fig. 9 näher eingegangen wird.

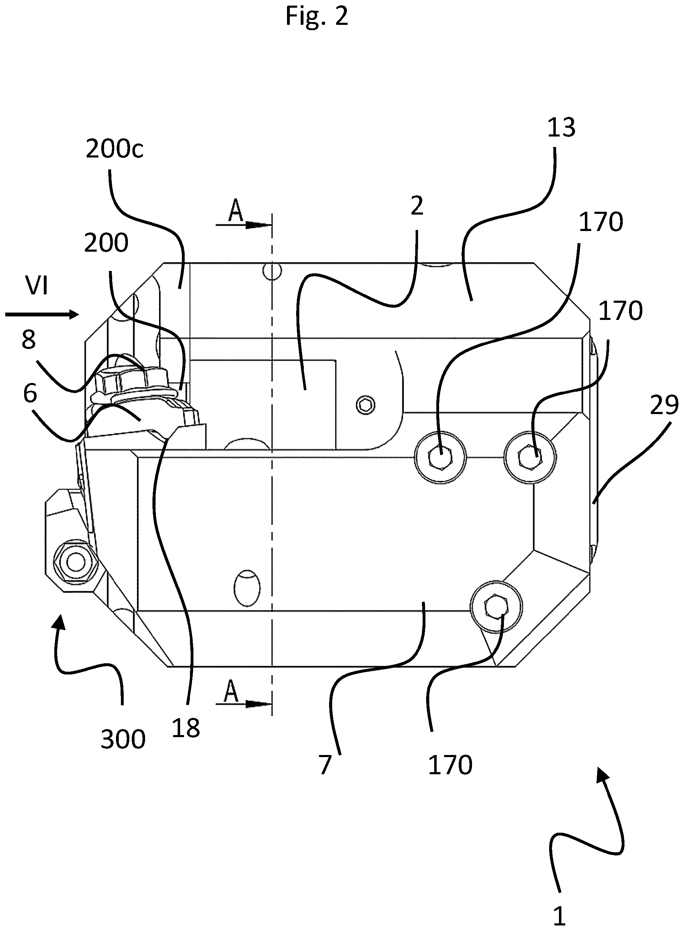

Fig. 2 zeigt das Zerspanungswerkzeug 1 in einer Stirnseitenansicht in Blickrichtung von dem Pfeil II in Fig. 1. Fig. 2 zeigt besonders gut, dass drei Befestigungsschrauben 170 den Halterungsarm 7 mit dem Brückenabschnitt 9 reversibel lösbar verbinden und dass die Spannpratze 6 aufseiten des Schneidelements 4 in eine V-Nut 18 von dem weiteren Schlitten 10 einrastet; die Spannpratze 6 aufseiten des Schneidelements 3 rastet in eine analoge V-Nut von dem Schneidelementhalter 200 ein.

Fig. 3 zeigt einen Längsschnitt von dem Zerspanungswerkzeug 1 gemäß den Schnittlinien A-A in Fig. 1. Fig. 3 zeigt besonders gut, dass das Zerspanungswerkzeug 1 eine Spindel 20 hat, wobei das Zweiflachelement 16 ein monolithischer Vorsprung von der Spindel 20 ist. Die Spindel 20 ist jeweils in das Flanschteil 14 und in den Werkzeugschlitten 2 eingesteckt. Im Bereich des Flanschteils 14 wird die Spindel 20 aufseiten des Werkzeugschlittens 2 von einem Doppelwälzlager 21 und aufseiten des Zweiflachelements 16 von einem einfach ausgebildeten Wälzlager 22 drehbar bezüglich der Verstellachse 100 gelagert. Das Doppelwälzlager 21 und das Wälzlager 22 werden zueinander durch eine auf die Spindel 20 aufgesteckte Hülse 23 beabstandet. Aufseiten des Werkzeugschlittens 2 ist ferner ein Spannring 23a auf die Spindel 20 aufgesteckt, so dass das Doppelwälzlager 21 durch die Hülse 23 und den Spannring 23a beidseitig eingespannt wird.

Auf den Spannring 23a ist ein Flanschdeckel 24 aufseiten des Werkzeugschlittens 2 unter einem Kontakt mit dem Doppelwälzlager 21 aufgesetzt. Der Flanschdeckel 24 ist durch in den Flanschdeckel 24 eingesteckte und in das Flanschteil 14 eingeschraubte Befestigungsschrauben 25 gesichert.

In den Werkzeugschlitten 2 ist eine Gewindebuchse 26 eingesetzt, welche durch in die Gewindebuchse 26 eingesteckte und in den Werkzeugschlitten 2 aufseiten des Flanschteils 14 eingeschraubte Befestigungsschrauben 27 mit dem Werkzeugschlitten 2 reversibel lösbar verbunden ist. Die Spindel 20 greift gewindemäßig in die Gewindebuchse 26 ein, so dass eine Drehung von der Spindel 20 bezüglich der Verstellachse 100 in eine lineare Verstellung von dem Werkzeugschlitten 2 umgewandelt wird, wobei der Werkzeugschlitten 2 beidseitig von der Schlittenführung 13 geführt wird. In den Werkzeugschlitten 2 ist außerhalb von der Gewindebuchse 26 aufseiten des Brückenabschnitts 9 eine Führungsbuchse 28 eingesetzt, welche die Spindel 20 abstützt. Die Spindel 20 wird von einer Schlittenbohrung 600 von dem Werkzeugschlitten 2 aufgenommen.

Fig. 3 zeigt außerdem besonders gut, dass der weitere Schlitten 10 eine Bohrung 10a zur Aufnahme von der Verstellschraube 12 hat. Fig. 3 zeigt ferner, dass die Verstellachse 100 eine Spindeldrehachse von der Spindel 20 ist.

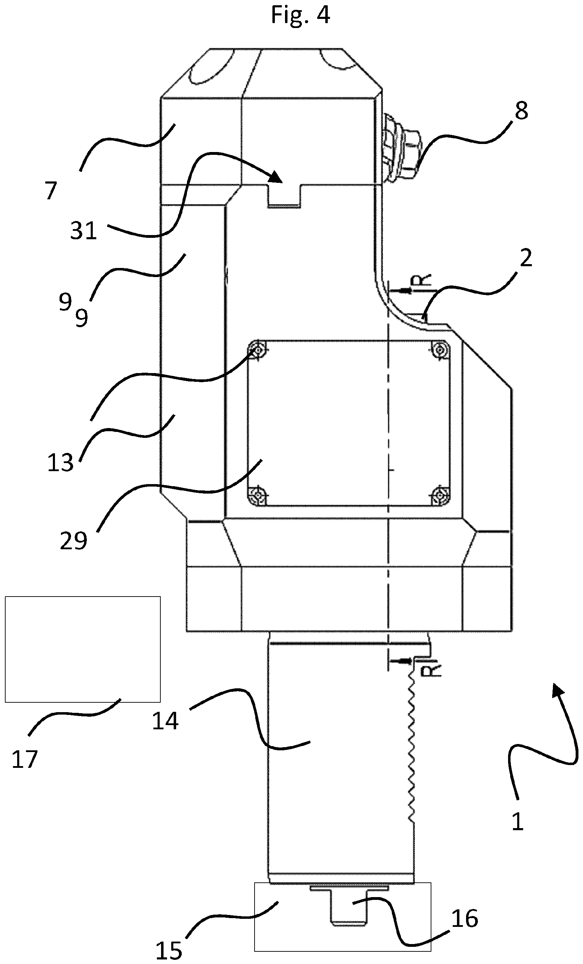

Fig. 4 zeigt das Zerspanungswerkzeug 1 in einer Seitenansicht gemäß der Blickrichtung von dem Pfeil IV in Fig. 1.

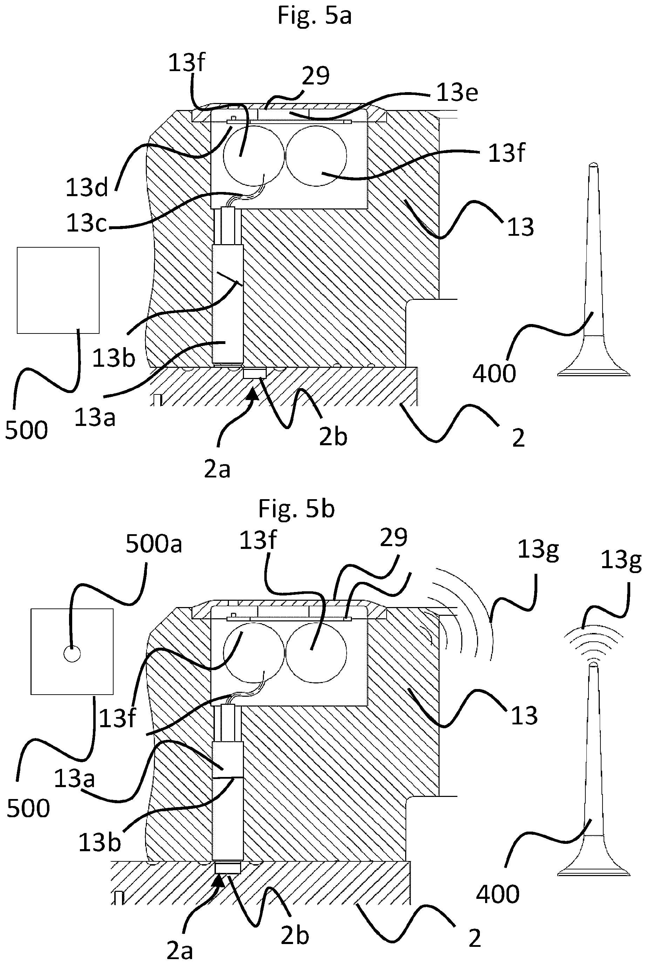

Fig. 4 zeigt, dass die Schlittenführung 13 einen Gehäusedeckel 29 hat, der durch vier Befestigungsschrauben 30, von denen nur eine mit dem Bezugszeichen 30 versehen ist, mit der Schlittenführung 13 reversibel lösbar verbunden ist; der Gehäusedeckel 29 verdeckt einen Positionsschalter, auf den in Fig. 5a und Fig. 5b näher eingegangen wird.

Fig. 4 zeigt ferner, dass der Halterungsarm 7 und der Brückenabschnitt 9 durch eine Feder-NutVerbindung 31 ineinander greifen und dass der Brückenabschnitt 9 ein monolithischer Fortsatz von der Schlittenführung 13 ist.

Fig. 5a zeigt einen weiteren Längsschnitt von dem Zerspanungswerkzeug 1 gemäß den Schnittlinien R-R in Fig. 4. In Fig. 5a befindet sich der Werkzeugschlitten 2 in der Position, so wie sie in Fig. 1 gezeigt wird. Diese Position ist eine Arbeitsposition von dem Werkzeugschlitten 2. Fig. 5a zeigt, dass der Werkzeugschlitten 2 einen Schalterbetätigungsbereich 2a hat, der der Schlittenführung 13 zugewandt ist. Der Schalterbetätigungsbereich 2a hat einen Magneten 2b, der in den Werkzeugschlitten 2 eingelassen ist.

Fig. 5a zeigt ferner, dass das Zerspanungswerkzeug 1 einen Positionsschalter 13a hat, der in die Schlittenführung 13 eingelassen ist und dem Schalterbetätigungsbereich 2a zugewandt ist. Der Positionsschalter 13a erstreckt sich senkrecht zur der Verstellachse 100. Der Positionsschalter 13a hat eine Schaltwippe 13b, die in Fig. 5a offen ist, so dass ein Schaltkontakt in dem Positionsschalter 13a offen ist, der Positionsschalter 13a damit ausgeschaltet ist. Der Positionsschalter 13a hat ein Kabel 13c, durch welches der Positionsschalter 13a mit einer Platine 13d und damit mit einem auf der Platine 13d angeordneten Positionssender 13e verbunden ist. Die Positionssender 13e hat eine darin integrierte Antenne und eine Schaltlogik, die erst dann die integrierte Antenne zum Senden eines Signals an eine externe Antenne 400 anregt, wenn die Schaltwippe 13b geschlossen ist.

Der Positionsschalter 13b und die Positionssender 13e werden mit elektrischer Energie von zwei Batterien 13f versorgt, wobei die Batterien 13f jeweils von der Platine 13d getragen werden und mit der Platine 13d reversibel lösbar verbunden sind.

Fig. 5a zeigt ferner eine optionale Anzeige 500 von dem Zerspanungswerkzeug 1. Die Anzeige 500 zeigt in dem ausgeschalteten Zustand von dem Positionsschalter 13a gemäß Fig. 5a kein optisches Signal an.

Fig. 5b zeigt den Längsschnitt von Fig. 5a mit dem Unterschied, dass der Werkzeugschlitten 2 von der Arbeitsposition gemäß Fig. 5a in eine Referenzposition verstellt wurde. In der Referenzposition gemäß Fig. 5b sind der Schalterbetätigungsbereich 2a und damit der Magnet 2b unterhalb von dem Positionsschalter 13a im Bereich von dem Positionsschalter 13a angeordnet, so dass die Schaltwippe 13b aufgrund des Magnetfelds von dem Magneten 2b in eine Schaltposition bewegt wurde, der Positionsschalter 13a also kontaktlos von dem Magneten 2b eingeschaltet wurde. Der Schaltkontakt wurde also in der Referenzposition geschlossen, so dass die Schaltlogik auf Basis davon die integrierte Antenne zum funkgebundenen Senden eines Referenzpositionssignals 13g anregt, der Positionssender 13e sendet damit das Referenzpositionssignal 13g. Das Referenzpositionssignal 13g wird von der externen Antenne 400 empfangen, so dass das Referenzpositionssignal 13g zum Beispiel von der Steuereinheit 17 zur Kenntnis genommen wird, also die Referenzposition als Basis für eine Verstellung von dem Werkzeugschlitten 2 zurück in die Arbeitsposition dient.

Fig. 5b zeigt ferner, dass die Anzeige 500 in dem eingeschalteten Zustand von dem Positionsschalter 13b gemäß Fig. 5b ein optisches Signal 500a anzeigt, also ein bezüglich des Referenzpositionssignals 13g weiteres Signal, was von einem Bediener des Zerspanungswerkzeugs 1 unmittelbar wahrgenommen werden kann.

Wenn der Schalterbetätigungsbereich 2a außerhalb von der Referenzposition gemäß Fig. 5b bewegt wird, bewegt sich die Schaltwippe 13b zurück in ihre Position gemäß Fig. 5a, wonach der Positionsschalter 13a ausgeschaltet wird.

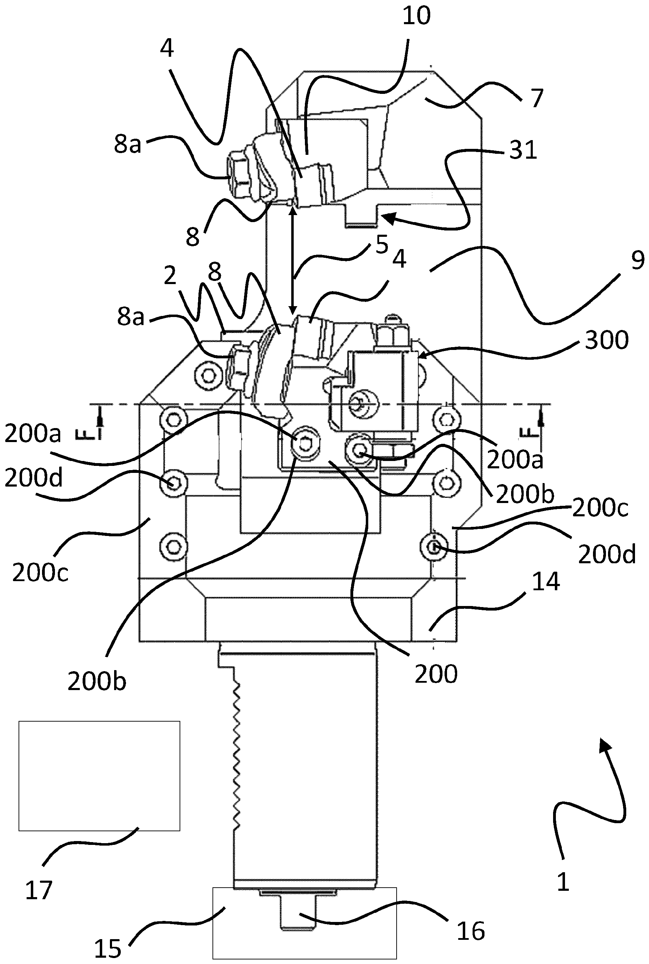

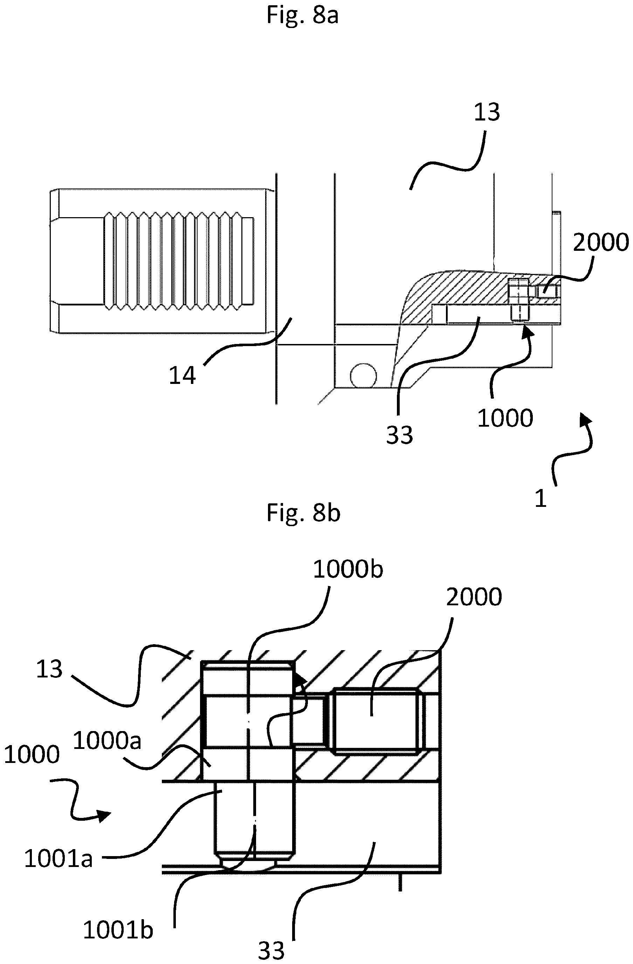

Fig. 6 zeigt das Zerspanungswerkzeug 1 in einer weiteren Seitenansicht gemäß dem Pfeil VI in Fig. 2. Fig. 6 zeigt, dass der Schneidelementhalter 200 durch Befestigungsschrauben 200a mit dem Werkzeugschlitten 2 reversibel lösbar verbunden ist, wobei die Befestigungsschrauben 200a jeweils in ein Langloch 200b von dem Schneidelementhalter 200 eingreifen, wobei sich die Langlöcher 200b jeweils parallel zur Verstellachse 100 erstrecken; die Langlöcher 200b werden für eine Feinverstellung von dem Schneidelementhalter 200 relativ zu dem Werkzeugschlitten 2 benötigt, wobei die Feinverstellung Bezug nehmend auf Fig. 8a und Fig. 8b näher beschrieben wird.

Fig. 6 zeigt ferner, dass die Schlittenführung 13 zwei Abdeckplatten 200c hat, wobei die Abdeckplatten 200c mit der Schlittenführung 13 durch Befestigungsschrauben 200d reversibel lösbar verbunden sind; von den Befestigungsschrauben 200d sind nur zwei mit dem Bezugszeichen 200d versehen, und zwar für jede Abdeckplatte 200c einmal. Die Abdeckplatten 200c decken den Werkzeugschlitten 2 teilweise ab, um den Werkzeugschlitten 2 so vor äußeren Umwelteinflüssen zu schützen.

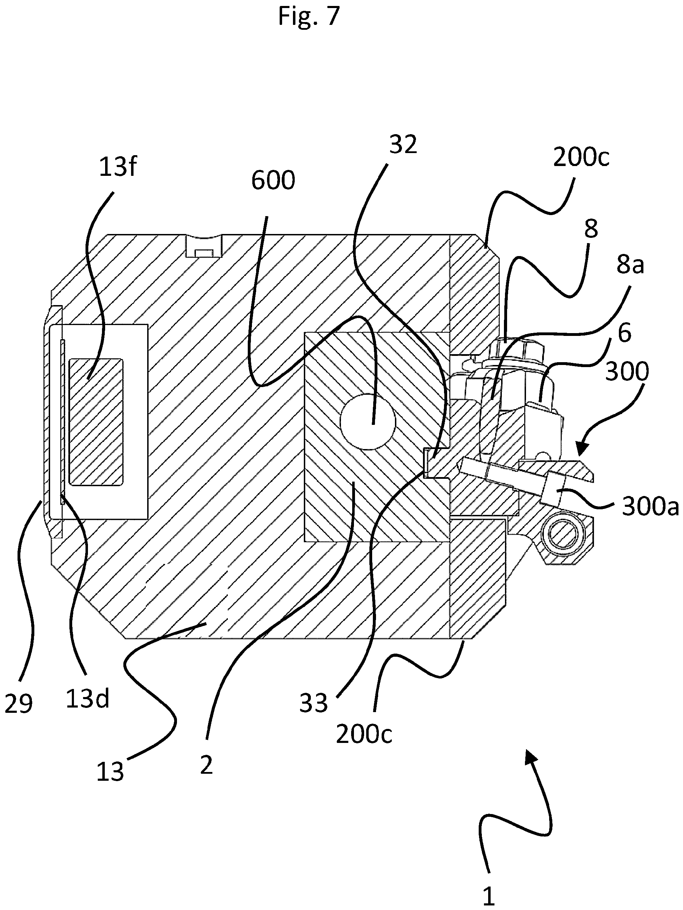

Fig. 7 zeigt einen Querschnitt von dem Zerspanungswerkzeug 1 gemäß den Schnittlinien F-F in Fig. 6. Fig. 7 zeigt, dass der Schneidelementhalter 200 eine Feder 32 hat, die in eine Nut 33 von dem Werkzeugschlitten eingreift. Fig. 7 zeigt ferner, dass das Dämpfungselement 300 durch eine schräg angestellte Befestigungsschraube 300a mit dem Schneideelementhalter 200 reversibel lösbar verbunden ist. Fig. 7 zeigt außerdem, dass die Schlittenführung 13 einen U-förmigen Querschnitt hat, in dessen Bereich der Werkzeugschlitten 2 geführt wird.

Fig. 8a und Fig. 8b zeigen einen Abschnitt von dem Zerspanungswerkzeug 1 ohne den Schneidelementhalter 200 und in einer Ansicht gemäß Fig. 1, wobei die Nut 33 freigelegt ist. Fig. 8a und Fig. 8b zeigen, dass das Zerspanungswerkzeug 1 einen verstellbaren Anschlag 1000 hat. Der Anschlag 1000 hat ein Wellenelement 1000a mit einer Längsachse 1000b und ein Wellenelement 1001a mit einer Längsachse 1001b, wobei das Wellenelement 1001a mit dem Wellenelement 1000a verbunden ist. Das Wellenelement 1000a ist in den Werkzeugschlitten 2 eingesteckt. Das Wellenelement 1001a ragt in die Nut 33 hinein. Die Längsachse 1000b ist senkrecht zur Verstellachse 100 orientiert. Die Längsachse 1001b ist senkrecht zur Verstellachse 100 orientiert. Die Längsachse 1001b fluchtet nicht mit der Längsachse 1000b, so dass das Wellenelement 1001a unter einer Drehung von dem Wellenelement 1000a eine Bewegungskomponente hat, die in der Zeichnungsebene von Fig. 8a und 8b liegt und parallel zur Verstellachse 100 orientiert ist. Ein solche Drehung wird freigegeben, wenn die Madenschraube 2000 gelöst wird, so dass die Madenschraube 2000 nicht mehr die Drehung von dem Wellenelement 1000a reibschlüssig blockiert. Wenn die Befestigungsschrauben 200a gelockert werden, wird der Schneidelementhalter 200 der beschriebenen Bewegungskomponente von dem Wellenelement 1001a folgend parallel zur Verstellachse 100 unter der Drehung von dem Anschlag 1000 bezüglich der Längsachse 1000b verstellt, weil die Feder 32 das Wellenelement 1001a aufnimmt, also im Bereich von dem Wellenelement 1001a unterbrochen ist, das Wellenelement 1001a aber beidseitig kontaktiert und eine Bewegungskomponente von dem Wellenelement 1001b senkrecht zur Zeichnungsebene von Fig. 8a und 8b freigibt. Die Langlöcher 200b erlauben die beschriebene Verstellung, die auch als Feinverstellung von dem Schneidelementhalter 200 beschrieben werden kann. Nach abgeschlossener Verstellung werden die Befestigungsschrauben 200a festgezogen.

Fig. 9 zeigt den inneren Aufbau von dem Dämpfungselement 300 in einem Längsschnitt, wobei der Längsschnitt zentral durch einen Kontaktstift 3000a von dem Dämpfungselement 300 geht. Der Kontaktstift 3000a besteht aus einem Hartmetall und ist aufseiten des Zerspanungsspalts 5 verrundet, so dass der Kontaktstift 3000a eine in den Zerspanungsspalt 5 eingeführte Bremsscheibe gleitend kontaktieren kann.

Der Kontaktstift 3000a ist reversibel rückstell bezüglich der in Fig. 9 gezeigten Ausgangsposition federnd gelagert, indem der Kontaktstift 3000a eine verstellbare Hülse 300b von dem Dämpfungselement 300 kontaktiert, welche eine zwischen der Hülse 300b und einem Verstellstift 300c von dem Dämpfungselement 300 eingespannte Tellerfeder 300d von dem Dämpfungselement 300 kontaktiert. Eine Vorspannung von der Tellerfeder 300d wird durch eine Verstellung von dem Verstellstift 300c geändert, indem der Verstellstift 300c unter einem Gewindeeingriff mit einem Gehäuse 300e tiefer oder weniger tief in das Gehäuse 300e eingedreht wird. Der Verstellstift 300c wird durch eine Mutter 300f von dem Dämpfungselement 300 axial gesichert. Das Gehäuse 300e ist in einen Halter 300g eingeschraubt, wobei das Gehäuse 300e einen Außendorn 300g hat, der im Eingriff mit einer Madenschraube 300h steht, so dass das Gehäuse 300e durch diesen Eingriff axial gesichert wird. Der Halter 300g ist durch die Befestigungsschraube 300a mit dem Schneidelementhalter 200 reversibel lösbar verbunden.

Das Dämpfungselement 300 sorgt aufgrund der beschriebenen federnden Lagerung von dem Kontaktstift 3000a dafür, dass Vibrationen von einer in den Zerspanungsspalt 5 eingeführten Bremsscheibe beim Plandrehen von der Bremsscheibe mit den Schneideelementen 3 und 4 gedämpft werden, indem der Kontaktstift 3000a die Bremsscheibe kontaktiert, während sich die Bremsscheibe relativ zu den Schneidelementen 3 und 4 und damit relativ zu dem Kontaktstift 3000a dreht.

Die Fig. 1 bis 9 zeigen ein Zerspanungswerkzeug 1, bei dem die Referenzposition von dem Werkzeugschlitten 2 einfach und zugleich präzise erfasst wird, indem der Positionsschalter 13a in der Referenzposition von Werkzeugschlitten 2 eingeschaltet ist und der Positionssender 13e ein Referenzpositionssignal 13 g sendet, welches der Referenzposition zugeordnet ist. Es wird ausdrücklich festgehalten, dass das Dämpfungselement 300 ein optionales Bauteil ist, das beschriebene Plandrehen der Bremsscheibe und Referenzieren des Werkzeugschlittens 2 jeweils auch ohne das Dämpfungselement 300 funktionieren.

## Patentansprüche

1. Zerspanungswerkzeug (1), wobei das Zerspanungswerkzeug (1) einen Werkzeugschlitten (2), eine Schlittenführung (13), ein Schneidelement (3) und ein weiteres Schneidelement (4) hat, wobei der Werkzeugschlitten (2) das Schneidelement (3) trägt, wobei die Schlittenführung (13) den Werkzeugschlitten (2) führt, wobei der Werkzeugschlitten (2) von der Schlittenführung (13) geführt von einer Referenzposition in eine Arbeitsposition verstellbar ist, wobei das Schneidelement (3) und das weitere Schneidelement (4) einen verstellbaren Zerspanungsspalt (5) bilden, wobei das Zerspanungswerkzeug (1) einen Positionsschalter (13a) und einen Positionssender (13e) hat, wobei der Positionsschalter (13a) und der Werkzeugschlitten (2) derart gekoppelt sind, dass, wenn sich der Werkzeugschlitten (2) in der Referenzposition befindet, der Positionsschalter (13b) eingeschaltet ist, und, wenn sich der Werkzeugschlitten (2) außerhalb von der Referenzposition befindet, der Positionsschalter (13b) ausgeschaltet ist, wobei der Positionssender (13e) mit dem Positionsschalter (13a) derart verbunden ist, dass, wenn der Positionsschalter (13a) eingeschaltet ist, der Positionssender (13e) ein Referenzpositionssignal (13g) sendet, und, wenn der Positionsschalter (13a) ausgeschaltet ist, der Positionssender (13e) das Referenzpositionssignal (13g) nicht sendet.

2. Zerspanungswerkzeug (1) nach Anspruch 1, wobei die Schlittenführung (13) den Positionsschalter (13a) trägt, wobei der Werkzeugschlitten (2) einen Schalterbetätigungsbereich (2a) hat, wobei der Schalterbetätigungsbereich (2a) den Positionsschalter (13a) in der Referenzposition kontaktlos einschaltet.

3. Zerspanungswerkzeug (1) nach Anspruch 2, wobei der Schalterbetätigungsbereich (2a) einen Magneten (2b) hat und der Positionsschalter (13a) auf Basis eines von dem Magneten (2b) erzeugten Magnetfelds einschaltbar ausgebildet und angeordnet ist.

4. Zerspanungswerkzeug (1) nach Anspruch 3, wobei der Positionsschalter (13a) auf Basis eines betragsmäßigen Feldstärkenvergleichs einschaltbar ausgebildet und angeordnet ist.

5. Zerspanungswerkzeug (1) nach einem der vorhergehenden Ansprüche, wobei sich der Positionsschalter (13a) im Wesentlichen senkrecht zu einer virtuellen Verstellachse (100) von dem Werkzeugschlitten (2) erstreckt.

6. Zerspanungswerkzeug (1) nach einem der vorhergehenden Ansprüche, wobei der Positionssender (13e) zum kabellosen Senden des Referenzpositionssignals (13g) ausgebildet und angeordnet ist.

7. Zerspanungswerkzeug (1) nach Anspruch 7, wobei der Positionssender (13e) zum funkgebundenen Senden des Referenzpositionssignals (13g) ausgebildet und angeordnet ist.

8. Zerspanungswerkzeug (1) nach einem der vorhergehenden Ansprüche, wobei das Zerspanungswerkzeug (1) einen reversibel lösbaren Energiespeicher (13f) hat, wobei der Energiespeicher (13f) zur Energieversorgung von dem Positionssender (13e) und/oder von dem Positionsschalter (13a) ausgebildet und angeordnet ist, wobei der Energiespeicher (13f) in die Schlittenführung (2) eingelassen angeordnet ist.

9. Zerspanungswerkzeug (1) nach einem der vorhergehenden Ansprüche, wobei das Zerspanungswerkzeug (1) eine Anzeige (500) hat, wobei die Anzeige (500) derart ausgebildet und angeordnet ist, dass, wenn sich der Werkzeugschlitten (2) in der Referenzposition befindet, die Anzeige (500) auf Basis des Referenzpositionssignals (13g) ein bezüglich des Referenzpositionssignals (13g) weiteres Referenzpositionssignal (500a) optisch anzeigt, und, wenn sich der Werkzeugschlitten (2) außerhalb der Referenzposition befindet, die Anzeige (500) das weitere Referenzpositionssignal (500a) nicht anzeigt.

10. Zerspanungswerkzeug (1) nach einem der vorhergehenden Ansprüche, wobei das Zerspanungswerkzeug (1) eine Spannpratze (6) hat, wobei die Spannpratze (6) das Schneidelement (3) reversibel lösbar fixiert.

11. Zerspanungswerkzeug (1) nach einem der vorhergehenden Ansprüche, wobei das Zerspanungswerkzeug (1) eine Spindel (20) hat, wobei die Spindel (20) mit dem Werkzeugschlitten (2) derart im Eingriff steht, so dass der Werkzeugschlitten (2) unter einer Spindeldrehung von der Spindel (20) bezüglich einer Spindeldrehachse (100) von der Spindel (20) parallel zur Spindeldrehachse (100) sowie relativ zur Spindel (20) verstellt wird.

12. Zerspanungswerkzeug (1) nach Anspruch 11, wobei das Zerspanungswerkzeug (1) eine Antriebseinheit (15) und eine Steuereinheit (17) hat, wobei die Antriebseinheit (15) derart ausgebildet und angeordnet ist, dass die Antriebseinheit (15) in einem aktivierten Zustand die Spindel (20) bezüglich der Spindeldrehachse (100) drehantreibt, wobei die Steuereinheit (17) derart ausgebildet und angeordnet ist, dass die Steuereinheit (17) die Antriebseinheit (15) auf Basis von einem Steuerbefehl aktiviert, wobei der Steuerbefehl ein codierter Betrag von einer Drehzahl von der Spindel (20) bezüglich der Spindeldrehachse (100) ist.

13. Zerspanungswerkzeug (1) nach Anspruch 12, wobei die Steuereinheit (17) derart ausgebildet und angeordnet ist, dass die Steuereinheit (17) in einem Referenzierzustand die Antriebseinheit (15) auf Basis von einem Referenzierbefehl aktiviert, so dass der Werkzeugschlitten (2) in dem Referenzierzustand von der Steuereinheit (17) verstellt wird, bis der Positionsschalter (13a) eingeschaltet ist.

14. Zerspanungswerkzeug (1) nach einem der vorhergehenden Ansprüche, wobei das Zerspanungswerkzeug (1) ein Dämpfungselement (300) hat, wobei das Dämpfungselement (300) einen Scheibenkontaktkörper (3000a) und ein Federelement (300d) hat, wobei das Federelement (300d) den Scheibenkontaktkörper (3000a) bezüglich einer Ausgangsposition von dem Scheibenkontaktkörper (3000a) reversibel rückstellbar lagert, wobei der Werkzeugschlitten (2) das Dämpfungselement (300) trägt, wobei das Dämpfungselement (300) aufseiten des Zerspanungsspalts (5) angeordnet ist.

15. Zerspanungswerkzeug (1) nach einem der vorhergehenden Ansprüche, wobei das Zerspanungswerkzeug (1) einen Schneidelementhalter (200) hat, wobei das Schneidelement (3) reversibel lösbar mit dem Schneidelementhalter (200) verbunden ist, wobei der Schneidelementhalter (200) reversibel lösbar mit dem Werkzeugschlitten (2) verbunden ist und gegen einen verstellbaren Anschlag (1000) anschlägt, wobei der Schneidelementhalter (200) in einem bezüglich des Werkzeugschlittens (2) reversibel gelösten Zustand sowie bezüglich eines gegenüber einer Ausgangsstellung verstellten Zustands des Anschlags (1000) relativ zu dem Werkzeugschlitten (2) verstellbar ist, so dass der Zerspanungsspalt (5) unter einer Verstellung von dem Schneidelementhalter (200) relativ zum Werkzeugschlitten (2) verstellt wird und der Werkzeugschlitten (2) nach der Verstellung gegen den Anschlag (1000) anschlägt.
